Europäisches Patentamt

European Patent Office

Office européen des brevets

(19)

(11) Numéro de publication: 0 398 832 A1

## (12) DEMANDE DE BREVET EUROPEEN

(21) Numéro de dépôt: 90460024.4

(22) Date de dépôt: 17.05.90

(51) Int. Cl.⁵: **H05H 1/46, H01J 37/32**

(30) Priorité: 18.05.89 FR 8906508

(43) Date de publication de la demande:
22.11.90 Bulletin 90/47

(84) Etats contractants désignés:
CH DE ES FR GB IT LI NL

(71) Demandeur: DEFITECH S.A.
75 rue Poul-Palud
F-22730 Trégastel(FR)

(72) Inventeur: **Chollet, Patrick**
**Ker Babu, Servel**
**F-22300 Lannion(FR)**
Inventeur: **Saada, Serge**
**Résidence Beauchamp**
**F-22300 Lannion(FR)**

(74) Mandataire: **Corlau, Vincent**
**c/o Cabinet Vidon Immeuble Germanium 80**
**avenue des Buttes de Coesmes**
**F-35700 Rennes(FR)**

(54) Réacteur à plasma perfectionné muni de moyens de couplage d'ondes électromagnétiques.

(57) Le domaine de l'invention est celui des réacteurs à plasma.

L'invention concerne un réacteur à plasma, du type comprenant une enceinte (3) susceptible de recevoir un flux gazeux (G), un générateur (1) d'ondes électromagnétiques haute fréquence, et des moyens (2) de couplage non résonant dudit générateur (1) avec ladite enceinte (3), lesdits moyens (2) de couplage comprenant au moins un cornet (21) à élargissement de section transversale essentiellement rectangulaire, dont les deux parois perpendiculaires à la direction du champ électrique (E) s'éloignent angulairement l'une de l'autre, les deux parois parallèles à la direction du champ électrique (E) restant sensiblement parallèles.

Préférentiellement, le réacteur de l'invention comprend un cornet à élargissement (21) et un cornet à rétrécissement (22) parallèlement à la direction du champ électrique (E) placés pour l'essentiel en succession dans lesdits moyens (2) de couplage.

L'invention permet notamment d'obtenir des plasmas de grande taille, de formes quelconques et présentant une grande homogénéité.

FIG.1

EP 0 398 832 A1

Le domaine de l'invention est celui des réacteurs à plasma.

L'invention s'applique notamment au traitement de surface d'échantillons, tels que, par exemple, la gravure d'une couche d'oxyde de silicium déposée sur un substrat en micro-électronique. Plus généralement, le réacteur à plasma de l'invention concerne le traitement de tout type d'objets, comprenant éventuellement des matériaux fragiles tels que des polymères, quels qu'en soient leur taille et leur nombre. Il permet en particulier l'obtention de plasmas de grandes dimensions.

On connaît déjà des réacteurs à plasma permettant un traitement de surfaces d'échantillons. De tels réacteurs peuvent notamment comprendre une enceinte susceptible de recevoir un flux gazeux choisi, et un générateur d'ondes électromagnétiques hautes fréquences. Le plasma est obtenu en mettant le flux gazeux en présence des ondes électromagnétiques.

Le réacteur comprend donc également des moyens de couplage de l'enceinte avec le générateur d'ondes électromagnétique. Pour être efficace, ce couplage doit être non-résonant avec l'enceinte. En d'autres termes, celle-ci ne doit pas dissiper sous forme de rayonnement électromagnétique l'énergie haute fréquence qui lui est communiquée en présence de gaz.

Une solution particulière pour assurer un couplage non-résonant avec une enceinte de grande taille est que la partie terminale des moyens de couplage comporte un cornet progressivement aminci dans un sens et élargi dans l'autre jusqu'à atteindre une section droite rectangulaire plate entourant complètement ladite enceinte.

Pour assurer notamment une distribution uniforme de l'énergie électromagnétique autour de l'enceinte, dans le but de contribuer à une homogénéité satisfaisante du plasma, les cornets utilisés au sein de ces moyens de couplage doivent offrir un fort gain tout en minimisant la modification de la phase du champ électrique entre l'entrée et la sortie du cornet.

Or, le facteur modificateur de phase dépend, en première approximation, d'une fonction du carré de l'ouverture du cornet, ce qui lui vaut d'être habituelle ment désigné par l'homme de l'art sous la dénomination "d'erreur quadratique de phase".

Il apparaît donc nécessaire de limiter autant que possible l'angle d'ouverture du cornet. Cela permet alors en outre de considérer les composantes des modes supérieurs du champ électrique comme négligeables devant celles du mode dominant.

En conséquence, l'obtention d'un gain élevé impose alors d'augmenter la longueur du cornet.

Cependant, l'encombrement de tels réacteurs, lié directement à la longueur des cornets, s'avère être pénalisant dans certaines applications nécessitant notamment l'emploi de plasma de grandes dimensions ou de formes quelconques.

En effet, en règle générale, les réacteurs à plasma sont placés dans des environnements de type salle blanche, dont le coût est très élevé, et essentiellement lié au volume des salles. Il apparaît donc très important de réduire l'espace occupé par de tels réacteurs.

Pour rendre homogène le plasma, en vue d'obtenir un meilleur traitement de surface d'échantillons par exemple, il peut également être prévu d'appliquer dans l'enceinte un champ magnétique de diffusion.

L'application d'un tel champ magnétique a l'inconvénient de consommer une grande quantité d'énergie, parfois supérieure à celle employée pour produire le plasma.

Il en résulte une limitation des dimensions du réacteur et, par conséquent, des dimensions du plasma obtenu, ce qui empêche le traitement de grands échantillons.

Par ailleurs, le plasma obtenu dans de tels réacteurs s'avère, pour certains types de traitement, présenter une homogénéité insuffisante.

L'invention a pour objectif de pallier ces différents inconvénients.

Plus précisément, l'invention a pour objectif de fournir un réacteur à plasma à encombrement réduit, permettant notamment le traitement d'échantillons de grande taille, tout en limitant le volume de la salle blanche nécessaire.

Un autre objectif de l'invention est de fournir un tel réacteur à plasma permettant l'obtention de plasmas de grandes dimensions, et de formes quelconques.

L'invention a également pour objectif de fournir un tel réacteur, présentant un plasma très homogène. Un objectif particulier est, par ailleurs, de rendre possible l'adaptation de l'homogénéité de ce plasma, ou dans certains cas particuliers, la création d'un plasma possédant des zones volontairement inhomogènes.

Un autre objectif de l'invention est de fournir un tel réacteur à plasma, présentant une importante dynamique de fonctionnement, tant en pression qu'en puissance, et fournissant un plasma très stable.

Un objectif particulier de l'invention est de fournir un réacteur dont les moyens de couplage sont aisés à fabriquer, en comparaison avec l'art antérieur, et notamment en ce qui concerne la qualité des états de surface.

L'invention a également pour objectif de fournir un réacteur à plasma susceptible d'application industrielle. Le réacteur de l'invention a ainsi pour objectifs particuliers de permettre le traitement de plusieurs échantillons simultanément, le traitement "à la chaîne" de séries d'échantillons, et/ou le traitement par plusieurs plasmas successifs d'un même échantillon.

Un autre objectif particulier de l'invention est de fournir un tel réacteur permettant l'obtention, à des vitesses de gravure élevées, de circuits micro-électroniques présentant une gravure de bonne homogénéité.

Ces objectifs, ainsi que d'autres qui apparaîtront par la suite sont atteints à l'aide d'un réacteur à plasma, du type comprenant une enceinte susceptible de recevoir un flux gazeux, un générateur d'ondes électromagnétiques haute fréquence, et des moyens de couplage non résonant dudit générateur avec ladite enceinte, lesdits moyens de couplage comprenant au moins un cornet à élargissement de section transversale essentiellement rectangulaire, dont les deux parois parallèles à la direction du champ électrique s'éloignent angulairement l'une de l'autre, les deux parois perpendiculaires à la direction du champ électrique restant sensiblement parallèles.

Dans un mode de réalisation avantageux, lesdits moyens de couplage comprennent également au moins un cornet à rétrécissement de section transversale essentiellement rectangulaire, dont les deux parois perpendiculaires à la direction du champ électrique se rapprochent angulairement l'une de l'autre, les deux parois parallèles à la direction du champ électrique restant sensiblement parallèles, et lesdits cornets étant placés pour l'essentiel en succession dans lesdits moyens de couplage.

Toutefois, il est tout à fait possible, selon l'invention, que les moyens de couplage ne comprennent qu'un cornet à élargissement.

Dans le cas où les moyens de couplage comprennent deux cornets, ledit cornet à élargissement se trouve indifféremment en amont ou en aval dudit cornet à rétrécissement.

Selon une caractéristique très avantageuse de l'invention, lesdits moyens de couplage comportent, sur au moins une partie d'au moins un desdits cornets, des obstacles à la propagation de l'onde électromagnétique, placés de façon à corriger l'erreur quadratique de phase du champ électrique.

Cette caractéristique permet de réduire la longueur des moyens de couplage de façon très appréciable, et jusqu'à un facteur 10.

Avantageusement, lesdits obstacles comprennent des contours internes de motifs définis symétriquement sur au moins une partie des deux parois non parallèles d'au moins un desdits cornets.

Dans un mode de réalisation préférentiel de l'invention, lesdits motifs sont définis par une surface cylindrique dont la génératrice s'étend longitudinalement sur lesdites parois.

De façon avantageuse, lesdits motifs forment sensiblement un court-circuit quart d'onde pour l'onde électromagnétique propagée.

Lesdits motifs peuvent par exemple comporter deux profils en U, l'ouverture en U étant tournée vers l'intérieur du cornet.

Dans un autre mode de réalisation avantageux, lesdits motifs sont définis par une surface cylindrique dont la génératrice s'étend transversalement sur lesdites parois, décrivant par exemple une succession de nervures d'épaisseur sensiblement constante et régulièrement espacées longitudinalement sur lesdites parois.

Préférentiellement, lesdits obstacles s'étendent au moins dans ledit cornet à élargissement amont. Cependant, il est tout à fait envisageable de disposer de tels obstacles dans plusieurs cornets, et notamment dans des cornets à rétrécissement.

De façon avantageuse, lesdits obstacles à la propagation des ondes électromagnétiques comprennent des obstacles spécifiques destinés à modeler localement l'homogénéité du champ électromagnétique produit.

Dans un mode de réalisation particulier de l'invention, lesdits profils en U sont situés sur les parois latérales dudit cornet à élargissement amont, l'ouverture du cornet étant égale à 120° environ, la profondeur du U est égale environ au quart de la valeur de la longueur d'onde propagée tandis que l'ouverture du U est égale environ au dizième de la valeur de la longueur d'onde propagée.

Avantageusement, les moyens de couplage de l'invention peuvent comprendre des moyens propres à supprimer au moins un mode prédéterminé de l'onde propagée.

Ces moyens de suppression de mode peuvent par exemple comprendre :
- des plaques situées suivant la direction de propagation, dans une partie du cornet à élargissement, entre les parois inférieure et supérieure dudit cornet, et réparties selon un espacement dépendant du ou des mode(s) à supprimer ;
- une plaque diélectrique en sortie de cornet ;
- un matériau diélectrique remplissant ledit cornet.

De façon avantageuse, ledit cornet à élargissement comporte des moyens d'accord tels que des vis pénétrantes réglables situées sur au moins une des parois inférieure et supérieure du cornet.

Dans un mode de réalisation préférentiel de l'invention, il est prévu un court-circuit du genre piston, entouré complètement par ladite partie terminale desdits moyens de couplage et disposé à l'opposé du ou desdits cornet(s) par rapport à l'enceinte, ledit piston étant ajusté pour définir un champ haute fréquence désiré dans l'enceinte.

Avantageusement, de façon à réduire le volume du plasma, ladite enceinte de forme générale cylindrique de révolution comprend un premier organe tubulaire interne mis sous vide, concentrique à ladite enceinte, la paroi dudit premier organe tubulaire étant constitué d'un matériau possédant de faibles pertes diélectriques. Il peut être prévu, à l'intérieur de ladite enceinte, un court-circuit couplé audit premier organe tubulaire et possédant deux plaques annulaires entourant cet organe tubulaire, lesdites plaques annulaires étant espacées l'une de l'autre d'une distance prédéfinie et réglable en vue de confiner le plasma dans la portion de cet organe tubulaire comprise entre lesdites plaques annulaires.

De plus, il est possible que ledit premier organe tubulaire loge intérieurement et concentriquement un deuxième organe tubulaire, le confinement du plasma s'effectuant dans l'espace compris entre les parois latérales des deux organes tubulaires, un premier porte-échantillon étant prévu à l'intérieur du premier organe tubulaire, au voisinage d'une première extrémité de ce dernier.

Préférentiellement, dans ce cas, le réacteur comprend des moyens d'amenée du flux gazeux disposés au voisinage d'une deuxième extrémité dudit premier organe tubulaire, opposée à la première, et des moyens de pompage situés à l'opposé desdits moyens d'amenée du flux gazeux.

Avantageusement, il peut être prévu un deuxième porte-échantillon, disposé à l'intérieur dudit premier organe tubulaire, au voisinage d'une deuxième extrémité de celui-ci, opposée à la première, le réacteur comprenant des moyens d'amenée du flux gazeux débouchant sensiblement au milieu de la zone de confinement du plasma, et des moyens de pompage situés au voisinage des première et deuxième extrémités dudit premier organe tubulaire.

De façon préférentielle, le(s) porte-échantillon(s) est (sont) mobile(s) en rotation autour d'un axe parallèle à l'axe du premier organe tubulaire.

Ledit deuxième organe tubulaire peut notamment être mis sous vide, ou contenir un corps peu absorbant électromagnétiquement et non plasmagène.

Avantageusement, il est équipé de moyens de confinement supplémentaires du plasma, tels que des éléments magnétiques.

Dans un autre mode de réalisation de l'invention, ladite enceinte comprend au moins un organe interne mis sous vide, possédant deux parois définissant un conduit recevant à une extrémité le flux gazeux choisi et débouchant à l'autre extrémité sur un convoyeur d'échantillon apte à faire défiler en translation un échantillon sensiblement perpendiculairement à la direction du flux gazeux.

De façon avantageuse, le réacteur comprend au moins deux organes internes en ligne, coopérant avec des moyens uniques de couplage à un générateur d'ondes électromagnétiques hyperfréquences commun, de façon à soumettre un échantillon placé sur ledit convoyeur à au moins deux traitements par plasma en une seule passe.

Selon des modes de réalisation particuliers, le réacteur comprend au moins un porte-échantillon comprenant au moins un des moyens suivants :
- moyens de chauffage dudit porte-échantillon ;
- moyens de refroidissement dudit porte-échantillon ;
- moyens de polarisation dudit porte-échantillon.

Dans un autre mode de réalisation, lesdits moyens de couplage comprennent au moins un cornet de section transversale essentiellement rectangulaire, dont les deux parois perpendiculaires à la direction du champ électrique s'éloignent angulairement l'une de l'autre, et dont les deux parois parallèles à la direction du champ électrique se rapprochent angulairement l'une de l'autre, et au moins deux parois opposées comportent, sur au moins une partie dudit cornet des obstacles à la propagation de l'onde électromagnétique, placés de façon à corriger les erreurs de phase du champ électrique et/ou la distribution du champ électromagnétique.

D'autres avantages et caractéristiques de l'invention apparaîtront à l'examen de la description détaillée ci-après et des dessins annexés sur lesquels :
- la figure 1 est une coupe longitudinale schématique d'un mode de réalisation d'un réacteur selon l'invention ;
- la figure 2 est une vue de dessus schématique correspondant à la coupe de la figure 1 ;
- la figure 3 est une coupe transversale d'un cornet sectoral amont du réacteur de la figure 1 ;
- la figure 4 est une coupe longitudinale schématique d'une variante d'un cornet sectoral amont ;
- la figure 5 est une coupe longitudinale schématique d'une varainte d'un cornet sectoral aval ;
- la figure 6 est une représentation schématique d'une autre variante d'un cornet sectoral amont ;
- les figures 7 et 8 illustrent schématiquement un autre mode de réalisation d'un réacteur selon l'invention ;
- la figure 9 illustre encore un autre mode de réalisation du réacteur selon l'invention ;
- la figure 10 présente un autre mode de réalisation d'un réacteur à plasma selon l'invention ;
- la figure 11 illustre également un autre mode de réalisation du réacteur selon l'invention.

Les dessins comportent pour l'essentiel des éléments de caractère certain. A ce titre, ils font partie intégrante de la description et pourront non seulement servir à mieux faire comprendre la description détaillée ci-après, mais aussi à contribuer, le cas échéant, à la définition de l'invention.

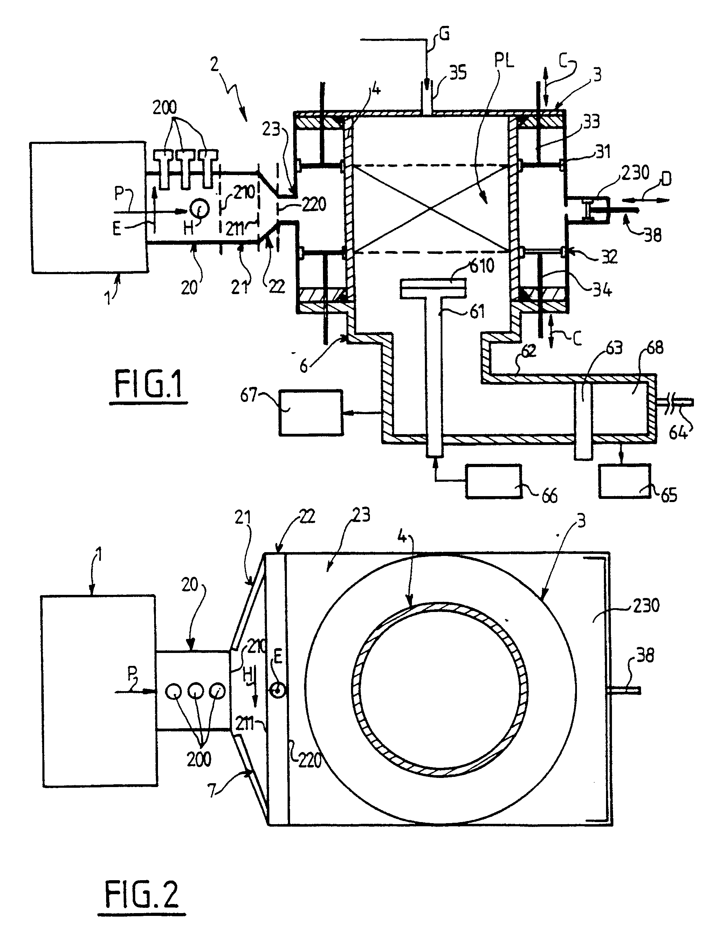

Dans le mode de réalisation représenté sur les figures 1 et 2, le réacteur à plasma comprend une enceinte métallique 3, par exemple en laiton, ayant une enveloppe de forme générale cylindrique de révolution.

L'enceinte 3 loge intérieurement et concentriquement un organe tubulaire 4 dont la paroi est constituée d'un matériau à faibles pertes diélectriques comme le quartz.

La partie supérieure de l'enceinte 3 est munie d'une ouverture circulaire, percée en son centre d'un orifice permettant le passage d'un tube 35 dont une extrémité débouche dans l'organe tubulaire interne 4.

Ce tube 35 peut être raccordé par des moyens conventionnels à des bouteilles (non représentées ici à des fins de simplification), contenant des gaz tels que de l'argon, de l'oxygène, de l'hélium.

Des moyens de contrôle (également non représentés) tels que des débitmètres permettent de contrôler le débit de flux gazeux dans le tube 35 ainsi que d'obtenir un mélange de gaz choisi dans l'enceinte.

En sa partie inférieure, l'organe tubulaire 4 débouche dans un support métallique 6, par exemple en aluminium, sur lequel repose l'enceinte 3. Ce support 6 comporte une boîte 62, de forme générale rectangulaire, possédant sur l'une de ses faces latérales, un sas 68 couplé à une vanne 63 du genre tiroir pour permettre l'introduction d'un échantillon 610 dans le tube 4 où se produit le plasma PL.

Cet échantillon, destiné à être traité par le plasma, est acheminé de l'extérieur de la boîte 62 vers un porte-échantillon 61 par l'intermédiaire d'une canne de transfert 64. Ce porte-échantillon 61 est placé concentriquement au tube 4 et est mobile en translation verticale.

Il est prévu des moyens de pompage primaire 54 établissant un vide grossier dans le tube 4 et la boîte 62 ainsi que des moyens de pompage secondaire 67 établissant un vide plus poussé dans ces mêmes organes. Ces moyens de pompage secondaire sont par exemple des pompes de type ROOTS ayant un débit de l'ordre de 250 m³/heure.

Le réacteur à plasma comprend encore un générateur d'ondes électromagnétiques haute fréquence 1 propre à opérer par exemple à une fréquence de l'ordre de 2,45 gigahertz et à une puissance de 1,2 kilowatt.

Des moyens de couplage 2 amènent les ondes électromagnétiques à l'enceinte 3 selon un couplage non résonant avec celle-ci, c'est-à-dire tel que l'enceinte 3 ne dissipe pas thermiquement l'énergie électromagnétique haute fréquence.

Il est prévu dans la partie initiale des moyens de couplage un coupleur bidirectionnel (non représenté ici). Celui-ci est suivi d'une partie intermédiaire 20 à section rectangulaire dans laquelle l'énergie électromagnétique se propage dans la direction longitudinale (flèche P). Le champ électrique E y est orienté transversalement dans le plan de la figure tandis que le champ magnétique H est orienté transversalement à la direction P et orthogonalement au champ électrique E. La notation conventionnelle du point contenu dans un cercle signifie que le champ H est orthogonal au plan de la figure et se dirige vers un observateur de cette figure.

Une pluralité de vis de réglage pénétrantes 200 (par exemple au nombre de 3) sont prévues sur cette partie intermédiaire 20 et permettent d'adapter "l'impédance" du réacteur en vue d'obtenir un bon rendement de la transmission hyperfréquence en direction de l'enceinte 3.

Les moyens de couplage 2 se prolongent, en direction de l'enceinte 3, par un tronçon dont la section transversale droite est continûment évolutive depuis une section amont 210 jusqu'à une section aval rectangulaire 220. Cette dernière section est élargie par rapport à la section amont, parallèlement au champ magnétique et rétrécie parallèlement au champ électrique. La géométrie de ce tronçon permet de définir un cornet sectoral amont 21 suivi d'un cornet sectoral aval 22.

Il convient de remarquer ici que la section aval rétrécie 220 permet d'accroître la directivité de l'onde électromagnétique incidente.

Dans le mode de réalisation préférentiel décrit, on passe de la section amont 210 à la section aval 220 successivement par :

- un cornet sectoral amont à élargissement 21 possédant deux parois latérales amont s'écartant progressivement l'une de l'autre depuis la section amont et deux parois inférieure et supérieure amont parallèles à la direction du champ magnétique, et par

- un cornet sectoral aval à rétrécissement 22 possédant deux parois latérales aval parallèles à la direction du champ électrique et deux parois inférieure et supérieure aval se rapprochant progressivement l'une de l'autre jusqu'à la section aval.

Plus généralement, les moyens de couplage selon l'invention peuvent comprendre plusieurs cornets à parois latérales s'éloignant, et/ou plusieurs cornets à parois inférieure et supérieure se rapprochant.

Selon une caractéristique essentielle de l'invention, les deux parois opposées et non parallèles du cornet sectoral amont 21 comportent des contours internes de motifs 7, symétriques l'un de l'autre et propres à agir sur l'erreur quadratique de phase du champ électrique. Les Demandeurs ont en effet observé de façon surprenante que l'adjonction de ces motifs particuliers contribuait à apporter une solution au problème posé. Il s'avère possible d'ajuster leurs caractéristiques géométriques ainsi que cela sera détaillé ci-après.

Ces motifs peuvent s'étendre sur toute la longueur du cornet, ou seulement sur une partie. Ils peuvent également se trouver sur un ou plusieurs cornets, à élargissement ou a rétrécissement.

Le cornet sectoral aval 22 est raccordé, au niveau de la section aval 220, à une partie terminale plate 23 des moyens de couplage, possédant une section transversale droite rectangulaire et entourant complètement l'enceinte 3 selon un couplage non résonant avec celle-ci.

L'enceinte 3, en sa partie intermédiaire, est subdivisée en deux demi-enceintes 31 et 32, séparées l'une de l'autre d'un espace ("gap" ou entrefer) de section droite par exemple rectangulaire plus faible que celle de la partie terminale plate 23. Ainsi, cette différence de section permet le couplage non résonant à l'enceinte 3 et la partie terminale plate 23 entoure complètement cette dernière au niveau de la séparation des deux demi-enceintes de manière à amener les ondes électromagnétiques au tube 4.

A l'intérieur de la portion 230 de la partie terminale plate 23, située à l'opposé de l'amenée des ondes électromagnétiques, est prévu un court-circuit 38 du genre piston. Celui-ci comprend une section droite rectangulaire plate sensiblement égale à celle de la portion 230.

La position du piston 38 est ajustée pour définir un champ électrique haute fréquence désiré dans l'enceinte 3. On remarquera que le court-circuit 38 présente les mêmes caractéristiques de répartition de d'onde électromagnétique que la partie terminale du cornet sectoral aval, ce qui permet d'assurer une symétrie dans la propagation des ondes.

Le réglage de la position du piston 38 permet d'obtenir des couplages meilleurs que 90 %. La partie intermédiaire 20 des moyens de couplage munie de ses vis d'adaptation 200 permet quant à elle d'affiner le couplage à mieux que 95 %.

Dans le cadre d'une application industrielle, la position du piston 38 est fixe tandis que dans le cas d'une application expérimentale, le piston 38 est mobile.

A l'intérieur de l'enceinte 3, il est prévu un second court-circuit haute fréquence couplé à l'organe tubulaire interne 4. Ce court-circuit comprend deux plaques annulaires 33 et 34 également de type piston.

Le rôle de ces plaques annulaires est de confiner plus ou moins le plasma PL qui prend naissance dans le tube 4, grâce à leur possibilité de translation verticale selon la flèche C.

Dans le cadre d'une application industrielle, les pistons 33 et 34 sont fixes tandis que dans le cadre d'une application expérimentale ils sont mobiles.

Une fois le plasma PL confiné, la possibilité de translation verticale du porte-échantillon 61 permet de porter l'échantillon 610 hors ou dans le plasma PL. Dans le cas de traitement de surfaces d'échantillons comprenant des matériaux fragiles tels que des polymères, il est préférable que l'échantillon soit porté hors du plasma, à proximité de celui-ci.

Pour des traitements de surfaces particuliers, notamment pour la gravure d'une couche d'oxyde de silicium déposée sur un substrat en micro-électronique, il est établi qu'un plasma d'ondes électromagnétiques seul ne permet pas d'obtenir une gravure rapide dudit oxyde de silicium.

Dans ce cas, le réacteur à plasma selon l'invention comprend en outre des moyens générateurs 66 propres à superposer un champ électromagnétique radiofréquence entre les moyens d'amenée du flux gazeux 35 et le porte-échantillon 61 en vue d'augmenter la vitesse de gravure.

Les moyens générateurs 66 délivrent par exemple une tension alternative d'une fréquence de l'ordre de 13 mégahertz. Cette tension alternative est par exemple appliquée au porte-échantillon 61 tandis que l'enceinte est mise à la masse.

On peut alors obtenir des vitesses de gravure de l'ordre de quelques milliers d'Angströms/minute avec une gravure de bonne homogénéité. Ce résultat s'explique par le fait que le plasma est très riche en ions positifs. En effet, ces dernier bombardent l'échantillon 610 polarisé négativement en présence du champ électromagnétique engendré par l'application de la tension alternative sur le porte-échantillon 61.

Parfois, il y a lieu également de chauffer ou de refroidir l'échantillon à l'aide de moyens appropriés (non représentés ici).

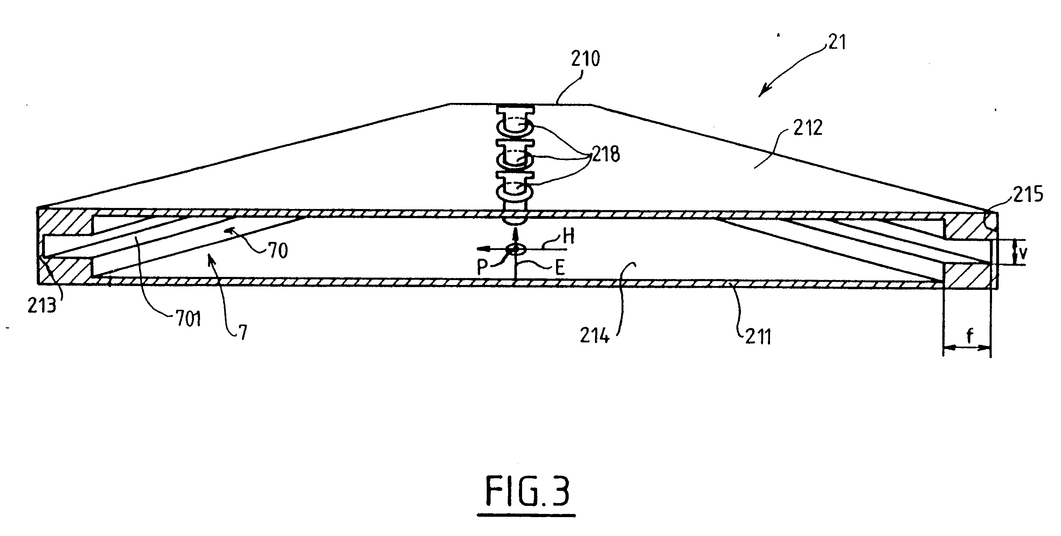

On se réfère maintenant plus particulièrement à la figure 3 pour décrire en détail les motifs 7 situés à l'intérieur du cornet sectoral amont 21.

Les motifs 7 constituent des obstacles à la propagation de l'onde électromagnétique et permettent de corriger d'une part les erreurs de phase du champ électrique en modifiant localement les équations de propagation de Maxwell et d'autre part la distribution du champ électromagnétique. Cette correction repose sur les principes de diffraction d'ondes électromagnétiques de Huygens.

D'une façon générale, dans ce mode de réalisation, les motifs sont définis par une surface cylindrique dont la génératrice s'étend longitudinalement sur les parois latérales 213 et 215 du cornet sectoral 21. On rappelle ici que le terme cylindrique doit s'entendre dans son sens général de surface engendrée par une droite ou génératrice se déplaçant parallèlement à elle-même sur une courbe ou directrice.

De tels motifs forment généralement sensiblement un court-circuit quart d'onde pour l'onde propagée.

Ils comprennent ici deux profils en U 70 dont l'ouverture 701 est tournée vers l'intérieur du cornet. La profondeur f du U est environ égale au quart de la valeur de la longueur d'onde propagée tandis que l'ouverture v du U est égale environ au dizième de la valeur de la longueur d'onde propagée.

Dans le cas présent, pour une longueur d'onde propagée de 12 cm, la profondeur f est environ égale à 1,2 cm. Aussi, l'adjonction de ces motifs sur les parois latérales du cornet permet de passer d'une section amont d'une dimension de 8,6 cm x 4,3 cm à une section élargie 211 dont les dimensions sont 60 cm x 4,3 cm, et ce sur une longueur de 15 cm avec une ouverture de cornet de 120° environ.

A titre indicatif, un cornet non-équipé de ces motifs 7 aurait une longueur environ 10 fois plus grande.

Il est également possible de munir l'une des parois inférieure 212 et supérieure 214, parallèles à la direction du champ électrique E, de moyens d'accord tels que des vis pénétrantes réglables 218 (par exemple au nombre de 3) et régulièrement espacées du quart de la valeur de la longueur d'onde propagée.

Bien entendu, les optimisations de la directivité de l'onde émergente, de l'erreur quadratique de phase et du gain du cornet tiennent compte de la fréquence de travail d'une part et de l'ouverture désirée d'autre part.

La succession des deux cornets contribue à augmenter encore l'efficacité du réacteur à plasma selon l'invention et permet, en combinaison avec l'emploi des motifs, d'obtenir une homogénéité encore plus poussée du plasma par une distribution uniforme de l'onde électromagnétique, puisqu'il s'avère possible d'ajuster les caractéristiques géométriques et d'implantation des motifs pour corriger localement les défauts d'inhomogénéité.

Il convient de noter ici, a contrario, que cette potentialité d'agir localement sur l'erreur quadratique de phase permet, dans certaines applications, de créer des plasmas possédant des zones volontairement inhomogènes.

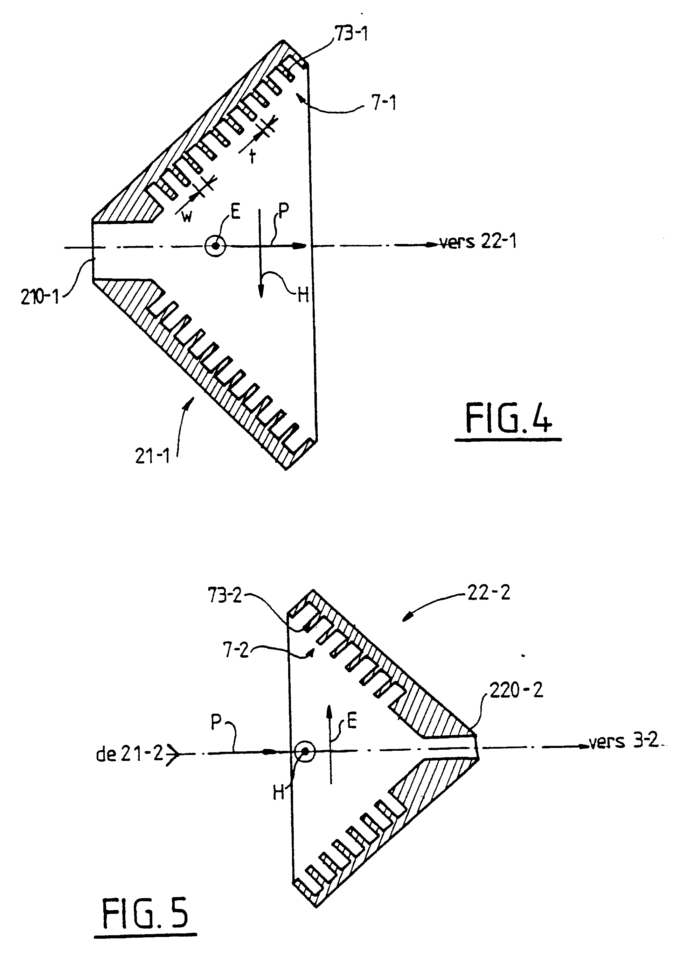

D'autres motifs propres à agir sur l'erreur quadratique de phase du champ électrique sont envisageables. Un exemple de ceux-ci est décrit sur la figure 4 sur lesquels les éléments analogues ou ayant des fonctions analogues à ceux représentés sur la figure 3 ont des références affectées d'un suffixe 1 par rapport à celles qu'ils avaient sur cette figure 3. Seules les différences entre ces deux figures seront décrites.

Les motifs 7-1 sont définis ici par une surface cylindrique dont la génératrice s'étend transversalement sur les parois latérales amont du cornet sectoral 21-1. Ces motifs sont réalisés, dans l'exemple de la figure 4, par une succession de nervures 73-1 d'épaisseur t sensiblement constante et régulièrement espacées l'une de l'autre d'une distance w dans le sens longitudinal. Les valeurs w et t dépendent bien entendu des formes géométriques du cornet et du mode propagé. Dans un mode particulier la valeur de w est égale au quart de la valeur de la longueur d'onde propagée tandis que la valeur t peut être de l'ordre de quelques dizièmes de la valeur de la longueur d'onde propagée.

Généralement, le cornet sectoral aval n'est pas muni de motifs propres à agir sur l'erreur quadratique de phase du champ électrique, en raison de son encombrement minime. Cependant, il est envisageable de munir les parois inférieure et supérieure du cornet sectoral aval 22-2 (figure 5) de motifs symétriques 7-2 composés par exemple d'une succession de nervures 73-2 analogues à celles décrites sur la figure 4.

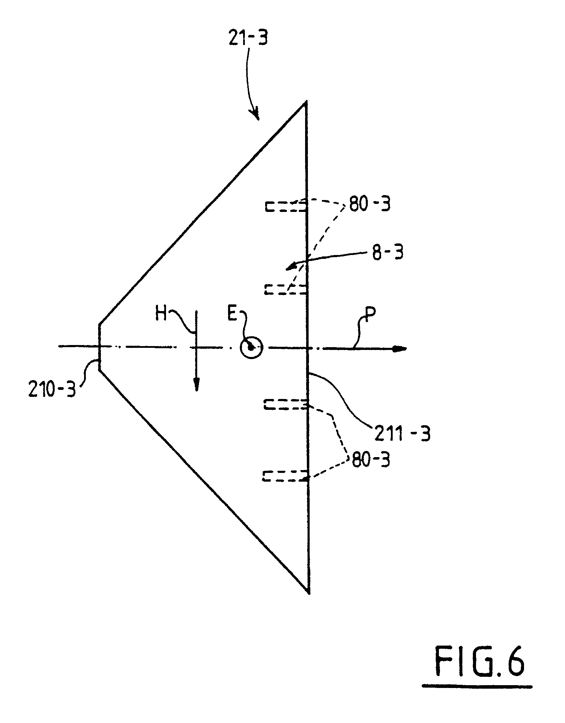

Le cornet sectoral amont peut comporter en variante des moyens propres à supprimer des modes prédéterminés de l'onde propagée. Un tel cornet est illustré schématiquement sur la figure 6 sur laquelle les éléments analogues ou ayant des fonctions analogues à ceux représentés sur la figure 3 ont des références affectées du suffixe 3 par rapport à celles qu'ils avaient sur cette figure 3. Seules les différences entre ces deux figures seront décrites.

Ces moyens 8-3, propres à supprimer les modes prédéterminés, comprennent des plaques 80-3 situées, suivant la direction de propagation P, dans une partie du cornet sectoral amont 21-3 entre les parois inférieure et supérieure de celui-ci. Ces plaques sont réparties selon un espacement dépendant du mode à supprimer. En d'autres termes leurs positions coïncident avec les zones d'amplitude maximale du champ électrique du mode à supprimer et forment un court-circuit entre les deux plaques inférieure et supérieure du cornet. Un tel cornet peut également comprendre des motifs symétriques 7 situés sur les parois non parallèles.

La suppression de certains modes peut également s'effectuer en plaçant une plaque en matériau diélectrique en sortie de cornet voire en remplissant complètement l'intérieur du cornet d'une mousse ou autre matériau diélectrique.

La mise en oeuvre du réacteur à plasma s'effectue comme suit :
- on ajuste d'abord le couplage entre le piston 38 et les moyens de couplage 2 ;
- on ajuste ensuite la distance séparant les deux plaques annulaires 33 et 34 de façon à confiner le plasma dans la zone désirée à l'intérieur du tube 4.

Des essais ont montré que les réacteurs à plasma selon l'invention présentent l'avantage d'une grande dynamique de fonctionnement, tant en pression qu'en puissance, avec des taux d'ondes stationnaires (TOS) faibles voire très faibles, et ce avec un encombrement réduit.

De plus, un plasma très stable peut être obtenu avec des variations relatives en pression et/ou en puissance importantes. Les conditions d'obtention du plasma sont facilement reproductibles. Des gaz tels que l'éthylène, l'azote, le chlorure de silicium peuvent être également utilisés pour le flux gazeux tout en conservant les mêmes caractéristiques de fonctionnement du réacteur.

Il semble que les ondes haute fréquence produites dans le gaz soient essentiellement des ondes de surface. En effet, on peut observer que la distribution du champ électromagnétique présente un maximum au voisinage de la paroi du tube 4 et un minimum au centre de ce tube. Le plasma, qui est donc homogène dans la portion comprise entre les plaques annulaires 33 et 34, est alors le siège d'ondes haute fréquence stationnaires de très forte intensité.

Les différents essais ont été conduits avec un réacteur à plasma dont les dimensions sont les suivantes :
- enceinte 3 : diamètre environ 400 mm, hauteur 300 mm ;
- organe tubulaire interne 4: diamètre environ 195 mm, hauteur environ 300 mm ;
- section amont 210 : 43 x 86 mm ;
- section de sortie 211 du cornet sectoral amont 21 : 43 x 600 mm ;
- section aval 220 : 600 x 10 mm ;
- longueur du cornet sectoral amont : 150 mm environ ;
- longueur du cornet sectoral aval : 30 mm environ ;
- dimensions du piston 38 : environ 600 x 10 mm.

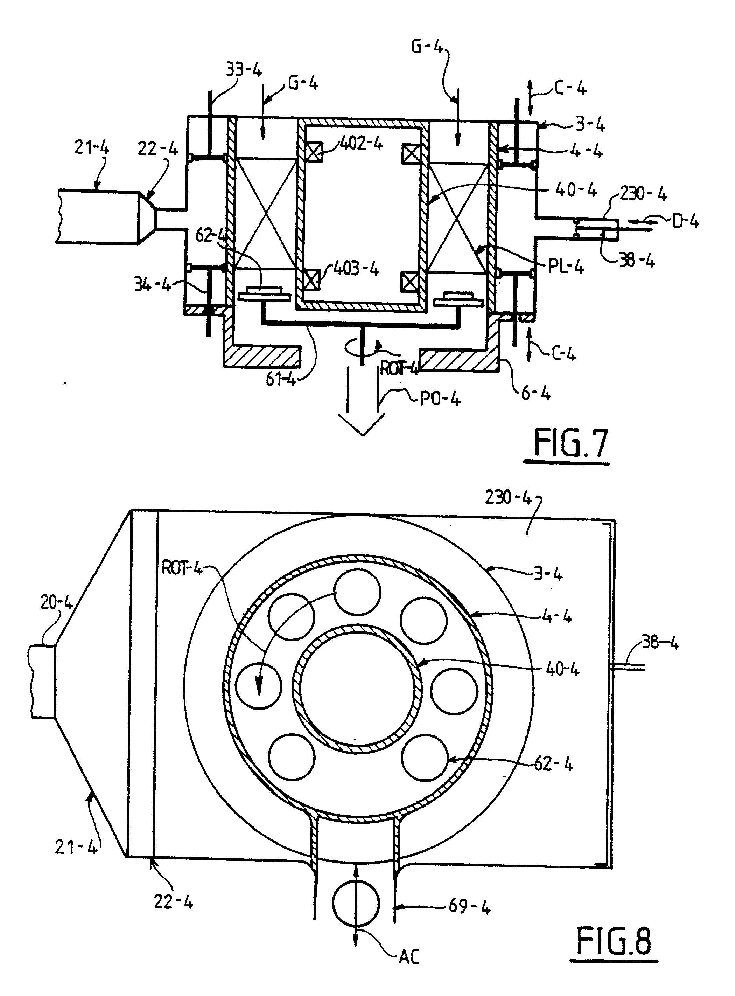

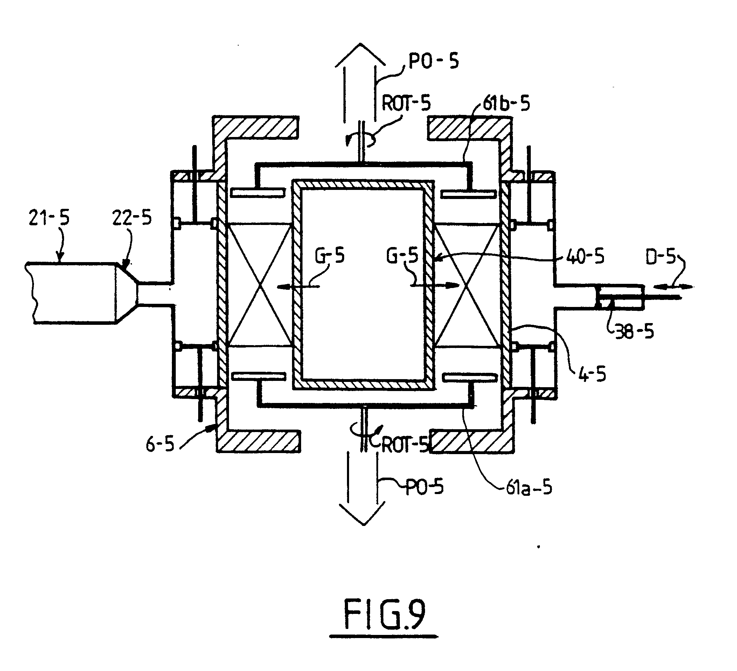

Dans certaines applications, il peut être intéressant de faire des traitements multi-échantillons tout en réduisant le volume de plasma. Un mode de réalisation d'un réacteur permettant une telle application est illustré sur les figures 7 et 8 sur lesquelles les éléments analogues ou ayant une fonction analogue à ceux représentés sur les figures 1 et 2 ont des références affectées du suffixe 4 par rapport à celles qu'ils avaient sur ces deux figures. Seules les différences entre ces quatre figures seront décrites ci-après.

Le volume du plasma PL-4 est réduit en logeant intérieurement et concentriquement dans l'organe tubulaire 4-4, un deuxième organe tubulaire 40-4 mis sous vide ($10^{-6}$ millibars), ou contenant un matériau électromagnétiquement très peu absorbant et non plasmagène tel que le quartz.

Le plasma PL-4 est alors confiné dans l'espace compris entre les parois latérales des deux tubes 4-4 et 40-4. Ceci a alors pour effet de diminuer le temps de traitement, d'augmenter les vitesses des flux gazeux, d'améliorer l'homogénéité du traitement.

Afin d'augmenter encore la précision de confinement du plasma, le deuxième tube interne 40-4 peut être équipé de moyens de confinement supplémentaires du plasma tels que des éléments magnétiques 402-4 et 403-4 propres à engendrer un champ magnétique de diffusion, ou bien encore de court-circuits de type piston analogues aux pistons 33-4 et 34-4. Ces moyens de confinement supplémentaires peuvent être situés à l'intérieur du tube 40-4 et/ou à l'extérieur.

Le porte-échantillon 61-4 est un disque annulaire placé au voisinage de l'extrémité inférieure du tube 4-4 et propre à être mu en rotation autour d'un axe vertical selon la flèche ROT-4. L'arrivée des gaz se fait alors suivant les flèches G-4 par l'extrémité opposée du tube 4-4.

Ce porte-échantillon peut être chauffé ou non, polarisé ou non à l'aide d'un champ électromagnétique radiofréquence. La direction de pompage des gaz est schématisée sur cette figure par la flèche PO-4.

Le chargement et le déchargement d'échantillons s'effectuent à partir d'un accès 69-4 selon la flèche AC. Ces chargement et déchargement peuvent se faire également de façon continue.

Il est possible de symétriser ce mode de réalisation comme le montre la figure 9 sur laquelle les éléments analogues ou ayant une fonction analogue à ceux représentés sur la figure 7 ont des références affectées du suffixe 5 par rapport à celles qu'ils avaient sur la figure 7. Seules les différences entre ces deux figures seront décrites.

Dans ce mode de réalisation, le réacteur comporte un deuxième porte-échantillon 61b-5 , analogue au premier porte-échantillon 61a-5, et placé en regard de ce dernier. Le pompage s'effectue alors de manière symétrique par le haut et par le bas de l'enceinte suivant les flèches PO-5.

L'injection du flux gazeux est assurée au milieu du tube 4-5 soit en utilisant un accès direct à l'aide d'un tube (non représenté ici) plongeant dans le plasma, soit en passant par le deuxième tube interne 40-5, suivant les flèches G-5. La présence d'un tel injecteur placé au centre du plasma ne perturbe pas celui-ci car il se situe dans une zone de champ électrique faible. Une telle structure permet notamment d'augmenter l'efficacité du réacteur sans accroître son encombrement.

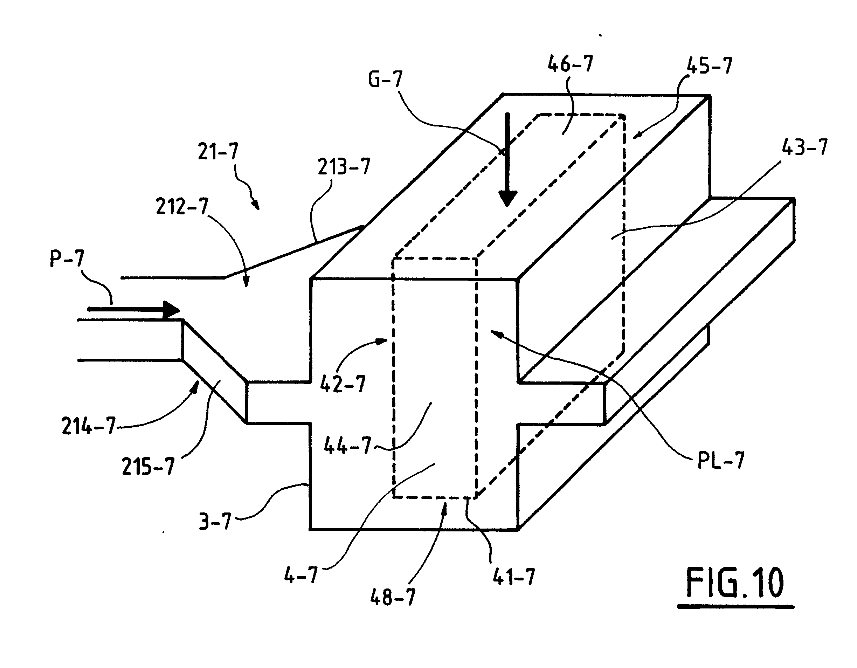

La figure 10 présente un autre mode de réalisation d'un réacteur à plasma selon l'invention, à moyens de couplage simplifiés. Sur cette figure, les éléments analogues ou ayant des fonctions analogues à celles qu'ils avaient sur la figure 1 ont des références affectées du suffixe 7 par rapport à celles qu'ils avaient sur cette même figure.

De façon surprenante, il est en effet apparu qu'il n'est pas forcément nécessaire, après avoir élargi sur un premier tronçon les moyens de couplage perpendiculairement à la direction du champ électrique, de les rétrécir parallèlement à cette direction sur un second tronçon.

Ainsi, les moyens de couplage peuvent comprendre uniquement un cornet 21-7, dont les parois verticales 213-7 et 215-7 s'éloignent angulairement, jusqu'à atteindre la largeur de l'enceinte 3-7, tandis que les parois horizontales 212-7 et 214-7 restent parallèles.

Ce cornet 21-7 peut bien sûr avantageusement comprendre des motifs faisant obstacle à la propagation des ondes tels que décrits précédemment, des moyens d'accord et/ou de moyens de suppressions de modes prédéterminés.

Dans le mode de réalisation présenté, l'enceinte 3-7, de grande taille, est de forme générale parallélépipédique. Cette enceinte loge un organe interne 4-7, mis sous vide, dans lequel le plasma est créé.

L'organe interne 4-7, de forme également parallélépipédique, comprend une armature de rigidification 41-7, sur laquelle prennent appui les plaques définissant son volume. Les deux parois 42-7 et 43-7 perpendiculaires à la direction de propagation P-7 des ondes électromagnétiques sont en matériau à faibles pertes diélectriques, tel que du quartz. Les plaques verticales 44-7, 45-7 et horizontales 46-7, 47-7 parallèles à la direction de propagation P-7 sont métalliques.

Le flux gazeux G-7 est introduit par la partie supérieure de l'enceinte 3-7 dans l'organe 4-7. Le plasma PL-7 est obtenu dans l'organe interne 4-7 dans un volume qui peut être variable, en fonction de courts-circuits réglables (non représentés) placés dans l'enceinte 3-7.

Les échantillons à traiter peuvent être introduits dans l'organe interne 4-7 par l'intermédiaire d'un support amovible. Ils peuvent également être placés sous l'organe interne 4-7, par exemple sur un convoyeur d'échantillons, le flux gazeux 6-7 débouchant sur ce convoyeur.

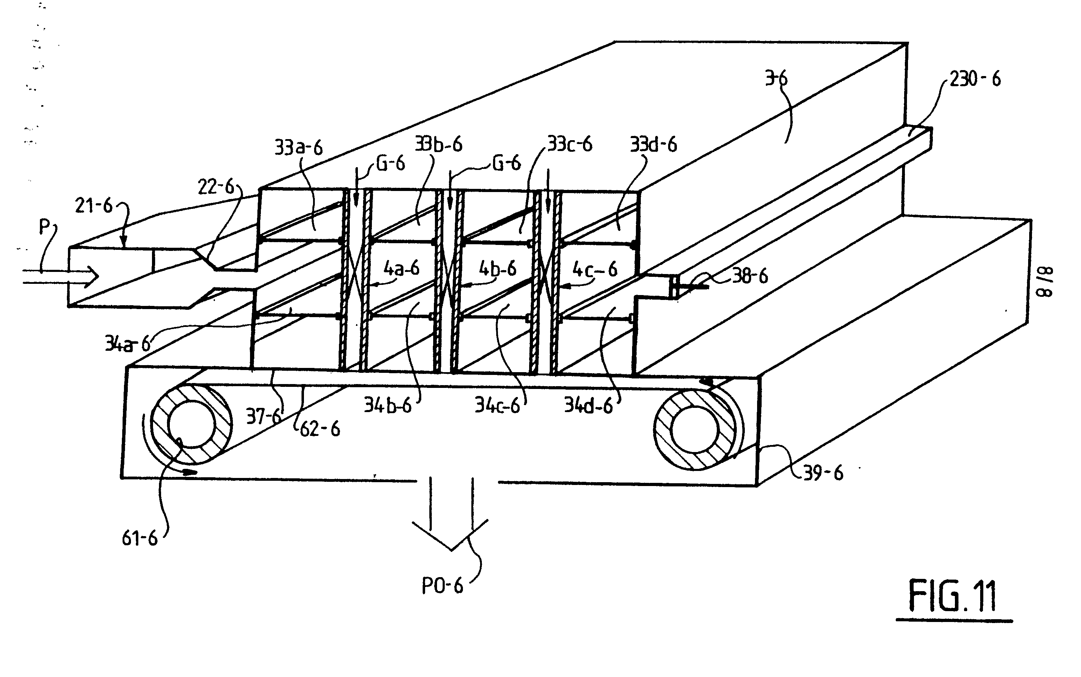

Dans certaines applications, notamment de revêtement de surface, il est en effet intéressant de déposer le plasma en ligne sur l'échantillon. Un mode de réalisation permettant une telle application est également illustré sur la figure 11 sur laquelle les éléments analogues ou ayant des fonctions analogues à ceux qu'ils avaient sur la figure 1 ont des références affectées du suffixe 6 par rapport à celles qu'ils avaient sur cette même figure. Seules les différences entre ces deux figures seront décrites ci-après.

L'enceinte 3-6 est de grande taille et de forme générale prismatique ayant par exemple une longueur, comptée parallèlement à la direction de propagation, de l'ordre de 200 mm, une largeur de l'ordre de 1200 mm et une hauteur de l'ordre de quelques dizaines de centimètres. Elle comprend au moins un organe interne mis sous vide 4a-6 dans lequel le plasma sera créé. La figure 10 illustre ici trois organes internes mis sous vide identiques 4a-6, 4b-6, 4c-6 nécessaires dans le cas d'un multi-traitement (plusieurs dépôts de plasma successifs) en une seule passe.

Chacun de ces organes internes possède deux parois rectangulaires sensiblement parallèles définissant un conduit recevant à une extrémité le flux gazeux choisi selon la flèche G-6 et débouchant à l'autre extrémité (partie basse) sur un convoyeur d'échantillon 61-6, situé dans la partie basse 39-6 de l'enceinte. Ce convoyeur est apte à faire défiler en translation, sensiblement perpendiculairement à la direction du flux gazeux, un échantillon tel qu'une feuille de verre ou de polymère. Il est prévu un joint étanche 37-6 entre les trois organes internes afin d'isoler la partie terminale 39-6 sous vide du reste de l'enceinte.

Les court-circuits internes situés dans l'enceinte sont ici des plaques rectangulaires 33a-6 à 33d-6 et 34a-6 à 34d-6. La direction de pompage est ici également schématisée par la flèche PO-6.

Le volume de plasma étant réduit au maximum (par exemple 10 mm x 1000 mm x 10 mm) les puissances haute fréquence nécessaires restent relativement faibles (quelques centaines de watt). Les vitesses de flux gazeux, et par conséquent les vitesses de dépôt par unité de surface peuvent être ainsi très élevées.

L'invention n'est pas limitée aux modes de réalisation ci-dessus décrits mais en embrasse toutes les variantes, et notamment les suivantes :
- bien que les motifs propres à agir sur l'erreur quadratique de phase soient préférentiellement situés dans le cornet sectoral amont, il est possible également que dans une seconde partie au moins du tronçon, par exemple le cornet sectoral aval, deux parois opposées non parallèles de celui-ci comportent des contours internes possédant de seconds motifs symétriques l'un de l'autre et propres à agir également sur l'erreur quadratique de phase du champ électrique. Les deux parties du tronçon contenant les premiers et deuxièmes motifs sont alors de préférence disjointes. Et les premiers et deuxièmes motifs peuvent être les uns ceux s'étendant longitudinalement et les autres ceux s'étendant transversalement sur les parois ;
- bien qu'il soit avantageux d'utiliser un tronçon comportant successivement un cornet sectoral amont et un comet sectoral aval, il n'est pas impossible de prévoir un tronçon dont la section transversale droite est simultanément progressivement élargie parallèlement au champ magnétique et rétrécie parallèlement au champ électrique ;
- dans chacun des modes de réalisation ci-dessus décrits, le porte-échantillon peut être chauffé ou non, refroidi ou non, polarisé ou non. De même, le court-circuit piston 38 peut être mobile ou non.

Bien entendu, certains des moyens décrits ci-dessus peuvent être omis dans les variantes où ils ne servent pas.

**Revendications**

1. Réacteur à plasma, du type comprenant une enceinte (3) susceptible de recevoir un flux gazeux (G), un générateur (1) d'ondes électromagnétiques haute fréquence, et des moyens (2) de couplage non résonant dudit générateur (1) avec ladite enceinte (3),
caractérisé en ce que lesdits moyens (2) de couplage comprennent au moins un cornet à élargissement (21) de section transversale essentiellement rectangulaire, dont les deux parois (213,215) parallèles à la direction du champ électrique (E) s'éloignent angulairement l'une de l'autre, les deux parois (212,214) perpendiculaires à la direction du champ électrique (E) restant sensiblement parallèles.

2. Réacteur selon la revendication 1, caractérisé en ce que lesdits moyens (2) de couplage comprennent également au moins un cornet à rétrécissement (22) de section transversale essentiellement rectangulaire, dont les deux parois perpendiculaires à la direction du champ électrique (E) se rapprochent angulairement l'une de l'autre, les deux parois parallèles à la direction du champ électrique (E) restant sensiblement parallèles,
et en ce que lesdits cornets (21,22) sont placés pour l'essentiel en succession dans lesdits moyens (2) de couplage.

3. Réacteur selon la revendication 2, caractérisé en ce que ledit cornet à élargissement (21) se trouve indifféremment en amont ou en aval dudit cornet à rétrécissement (22).

4. Réacteur selon l'une quelconque des revendications 1 à 3, caractérisé en ce que lesdits moyens (2) de couplage comportent, sur au moins une partie d'au moins un desdits cornets (21,22), des obstacles (7) à la propagation de l'onde électromagnétique, placés de façon à corriger l'erreur quadratique de phase du champ électrique.

5. Réacteur selon la revendication 4, caractérisé en ce que lesdits obstacles comprennent des contours internes (7) de motifs définis symétriquement sur au moins une partie des deux parois (213,215) non parallèles d'au moins un desdits cornets (21,22).

6. Réacteur selon la revendication 5, caractérisé en ce que lesdits motifs (7) sont définis par une surface cylindrique dont la génératrice s'étend longitudinalement sur lesdites parois (213,215).

7. Réacteur selon l'une quelconque des revendications 5 ou 6, caractérisé en ce que lesdits motifs (7) forment sensiblement un court-circuit quart d'onde pour l'onde électromagnétique propagée.

8. Réacteur selon l'une quelconque des revendications 6 et 7, caractérisé en ce que lesdits motifs (7) comportent deux profils en U (70), l'ouverture en U étant tournée vers l'intérieur du cornet.

9. Réacteur selon la revendication 5, caractérisé en ce que lesdits motifs (7-1) sont définis par une surface cylindrique dont la génératrice s'étend transversalement sur lesdites parois.

10. Réacteur selon la revendication 9, caractérisé en ce que les motifs (7-1) comprennent une succession de nervures (73-1) d'épaisseur sensiblement constante et régulièrement espacées longitudinalement sur lesdites parois (213,215).

11. Réacteur selon l'une quelconque des revendications 2 à 10, caractérisé en ce que lesdits obstacles à la propagation des ondes électromagnétiques comprennent des obstacles spécifiques destinés à modeler localement l'homogénéité du champ électromagnétique produit.

12. Réacteur selon la revendication 8, caractérisé en ce que lesdits profils en U (70) sont situés sur les parois latérales (213,215) dudit cornet à élargissement amont (21),
et en ce que l'ouverture du cornet étant égale à 120° environ, la profondeur du U (70) est égale environ au quart de la valeur de la longueur d'onde propagée tandis que l'ouverture du U (70) est égale environ au dizième de la valeur de la longueur d'onde propagée.

13. Réacteur selon l'une quelconque des revendications 1 à 12, caractérisé en ce qu'il comprend des moyens (8-3) propres à supprimer au moins un mode prédéterminé de l'onde propagée.

14. Réacteur selon la revendication 10 et l'une quelconque des revendications 1 à 13, caractérisé en ce que lesdits moyens de suppression de modes (8-3) comprennent au moins un des moyens suivants :
- des plaques (80-3) situées suivant la direction de propagation, dans une partie du cornet à élargissement (21-3), entre les parois inférieure (214) et supérieure (212) dudit cornet, et réparties selon un espacement dépendant du ou des mode(s) à supprimer ;
- une plaque diélectrique en sortie de cornet ;
- un matériau diélectrique remplissant ledit cornet.

15. Réacteur selon l'une quelconque des revendications 1 à 14, caractérisé en ce que ledit cornet à élargissement (21) comporte des moyens d'accord (218) tels que des vis pénétrantes réglables situées sur au moins une des parois inférieure (214) et supérieure (212) du cornet (21).

16. Réacteur selon l'une quelconque des revendications 1 à 15, caractérisé en ce qu'il est prévu un court-circuit du genre piston (38), entouré complètement par ladite partie terminale (23) desdits moyens (2) de couplage et disposé à l'opposé du ou desdits cornet(s) (21,22) par rapport à l'enceinte (3), ledit piston (38) étant ajusté pour définir un champ haute fréquence désiré dans l'enceinte (3).

17. Réacteur selon l'une quelconque des revendications 1 à 16, caractérisé en ce que ladite enceinte (3), de forme générale cylindrique de révolution comprend un premier organe tubulaire interne mis sous vide (4), concentrique à ladite enceinte (3), la paroi dudit premier organe tubulaire étant constitué d'un matériau possédant de faibles pertes diélectriques,
et en ce qu'il est prévu, à l'intérieur de ladite enceinte (3), un court-circuit couplé audit premier organe tubulaire (4) et possédant deux plaques annulaires (33,34) entourant cet organe tubulaire (4), lesdites plaques annulaires étant espacées l'une de l'autre d'une distance prédéfinie et réglable en vue de confiner le plasma dans la portion de cet organe tubulaire (4) comprise entre lesdites plaques annulaires.

18. Réacteur selon la revendication 17, caractérisé en ce que ledit premier organe tubulaire (4) loge intérieurement et concentriquement un deuxième organe tubulaire (40-4), le confinement du plasma s'effectuant dans l'espace compris entre les parois latérales des deux organes tubulaires,
et en ce qu'il est prévu un premier porte-échantillon (61) à l'intérieur du premier organe tubulaire (4), au voisinage d'une première extrémité de ce dernier.

19. Réacteur selon la revendication 18, caractérisé en ce qu'il comprend des moyens d'amenée du flux gazeux (G) disposés au voisinage d'une deuxième extrémité dudit premier organe tubulaire (4-4), opposée à la première, et des moyens de pompage situés à l'opposé desdits moyens d'amenée du flux gazeux (G).

20. Réacteur selon la revendication 18, caractérisé en ce qu'il est prévu un deuxième porte-échantillon (61b-5), disposé à l'intérieur dudit premier organe tubulaire (4-5), au voisinage d'une deuxième extrémité de celui-ci, opposée à la première,
en ce qu'il comprend des moyens d'amenée du flux gazeux (G) débouchant sensiblement au milieu de la zone de confinement du plasma,
et en ce que des moyens de pompage sont situés au voisinage des première et deuxième extrémités dudit premier organe tubulaire (4-5).

21. Réacteur selon l'une quelconque des revendications 18 à 20, caractérisé en ce que le(s) porte-échantillon(s) est (sont) mobile(s) en rotation autour d'un axe parallèle à l'axe du premier organe tubulaire (4-5).

22. Réacteur selon l'une quelconque des revendications 18 à 21, caractérisé en ce que ledit deuxième organe tubulaire (4-4) est mis sous vide.

23. Réacteur selon l'une quelconque des revendications 18 à 21, caractérisé en ce que le deuxième organe tubulaire (4-4) contient un corps peu absorbant électromagnétiquement et non plasmagène.

24. Réacteur selon l'une quelconque des revendications 18 à 23, caractérisé en ce que ledit deuxième organe tubulaire (4-4) est équipé de moyens de confinement supplémentaires du plasma (402-4), tels que des éléments magnétiques.

25. Réacteur selon l'une quelconque des revendications 1 à 16, caractérisé en ce que ladite enceinte (3) comprend au moins un organe interne mis sous vide (4a-6, 4b-6, 4c-6), possédant deux parois définissant un conduit recevant à une extrémité le flux gazeux (G-6) choisi et débouchant à l'autre extrémité sur un convoyeur (61-6) d'échantillon apte à faire défiler en translation un échantillon sensiblement perpendiculairement à la direction du flux gazeux.

26. Réacteur selon la revendication 25, caractérisé en ce qu'il comprend au moins deux organes internes (4a-6, 4b-6, 4c-6) en ligne, coopérant avec des moyens (2) uniques de couplage à un générateur (1) d'ondes électromagnétiques hyperfréquences commun, de façon à soumettre un échantillon placé sur ledit convoyeur (61-6) à au moins deux traitements par plasma en une seule passe.

27. Réacteur à plasma selon l'une quelconque des revendications 1 à 26, caractérisé en ce que lesdits moyens (2) de couplage comprennent au moins un cornet de section transversale essentiellement rectangulaire, dont les deux parois perpendiculaires à la direction du champ électrique s'éloignent angulairement l'une de l'autre, et dont les deux parois parallèles à la direction du champ électrique se rapprochent angulairement l'une de l'autre,
et en ce que au moins deux parois opposées comportent, sur au moins une partie dudit cornet des obstacles (7) à la propagation de l'onde électromagnétique, placés de façon à corriger les erreurs de phase du champ électrique et/ou la distribution du champ électromagnétique.

FIG.1

FIG.2

FIG.3

FIG.4

FIG.5

FIG.6

FIG.7

FIG.8

FIG.9

FIG.10

8/ 8

230 - 6

3-6

38-6

39-6

33d-6

33c-6

4c-6

34d-6

33b-6

G-6

4b-6

34c-6

G-6

33a-6

4a-6

34b-6

P0-6

62-6

37-6

61-6

22-6

34a-6

21-6

P

FIG.11

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 112 733 (G. LISITANO) <br> * Revendications; figures 1-5 * <br> --- | 1 | H 05 H 1/46 <br> H 01 J 37/32 |
| A | US-A-3 860 854 (D.D. HOLLISTER) <br> * Abrégé; figures 6-9,13 * <br> --- | 1 | |
| A | EP-A-0 188 206 (IBM) <br> ----- | | |

DOMAINES TECHNIQUES
RECHERCHES (Int. Cl.5)

H 05 H
H 01 J

Le présent rapport a été établi pour toutes les revendications

| Lieu de la recherche | Date d'achèvement de la recherche | Examinateur |
|---|---|---|
| LA HAYE | 24-08-1990 | ERRANI C. |

EPO FORM 1503 03.82 (P0402)